# EUROPEAN PATENT SPECIFICATION

(11) **EP 2 245 725 B1**
(45) Date of publication and mention of the grant of the patent: **29.02.2012**
(21) Application number: 09715631.9
(22) Date of filing: 23.02.2009
(51) Int. Cl.: H02M 3/158, H02P 7/29, H03K 17/16, H03K 17/687, H02M 7/5387

(54) **H-BRIDGE CIRCUIT AND METHOD FOR OPERATING SUCH CIRCUIT**
H-BRÜCKENSCHALTUNG UND VERFAHREN ZUM BETRIEB EINER SOLCHEN SCHALTUNG
CIRCUIT À PONT EN H ET PROCÉDÉ DE FONCTIONNEMENT D'UN TEL CIRCUIT

(30) Priority: 27.02.2008 EP 08152028
(43) Date of publication of application: 03.11.2010
(73) Proprietor: IEE International Electronics & Engineering S.A., 6468 Echternach (LU)
(72) Inventor: LAMESCH, Laurent, L-4881 Lamadelaine (LU)
(74) Representative: Office Freylinger
(86) International application number: PCT/EP2009/052128
(87) International publication number: WO 2009/106508

(56) References cited:
- US-A- 5 838 515
- US-A1- 2005 141 120
- US-A1- 2005 264 920
- US-B1- 6 374 043

## Description

### Technical field

The present invention generally relates to a H-bridge circuit for driving electrical loads with a defined current and to a method for operating such an H-Bridge circuit in current sourcing mode.

### Background Art

It is well known in the art to use H-bridge circuits for supplying a defined current to a load. One specific method to do so is to use a fully linear H-bridge which has low efficiency. Additionally, the measurement of the actual value of the current into the load and an overall feedback loop to control the current into the load are required.

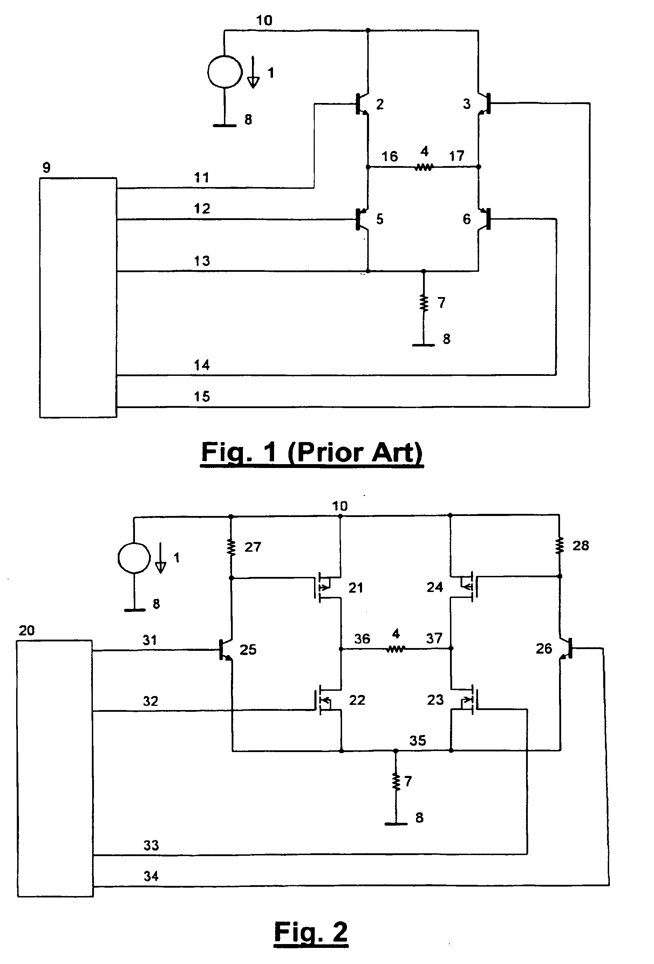

A possible implementation of a H-bridge operating in linear mode is shown in Fig. 1. In this circuit diagram, the different reference numerals denote the following elements:
- 1: a power supply voltage source,
- 2, 3: NPN transistors,
- 4: the load,
- 5, 6: PNP transistors,
- 7: a shunt resistor,
- 8: the circuit ground,
- 9: a control circuit,
- 10: the supply voltage node,
- 11: the control node for transistor 2,
- 12: the control node for transistor 5,
- 13: the feedback node of the load current measurement,
- 14: the control node for transistor 6,
- 15: the control node for transistor 7,
- 16: the left output node of the H-bridge,
- 17: the right output node of the H-bridge.

Bipolar transistors are shown in this figure, but other transistor types, like Mosfet transistors can also be used instead. The load is shown in the circuit diagram as resistor, but other load types, such as complex or non-linear loads may also be used instead.

Transistors 2 and 5, and 3 and 6 each constitute a voltage follower. The control circuit 9 supplies control voltages to the H-bridge in such a way that the transistor bias currents are set correctly, so that the current waveform through the load 4 is substantially equal to the required current waveform, and that the amplitude of the current through the load is substantially equal to the required amplitude. The transistor bias currents are established by the control circuit by setting the differences between the voltages of control nodes 11 and 12, and 14 and 15 respectively to a constant level. The required current waveform is applied to the load by the control circuit by setting the mean of the voltages of the control nodes 11 and 12 to the required waveform, and by setting the mean of the voltages of the control nodes 14 and 15 to the inverted required waveform. In this manner, the right output node of the H-bridge, 17, is always in opposite phase compared to the left output node of the H-bridge, 16. The control circuit 9 also measures the actual value of the current amplitude through the load 4 by measuring the voltage amplitude on feedback node 13, which is the amplitude of the voltage drop through the shunt resistor 7, and thereby substantially equal to the amplitude of the current through the load 4 multiplied by the resistance of shunt resistor 7. A control loop inside the control circuit 9 sets the signal amplitudes on the control nodes 11, 12, 14, 15 in such a way that the required load current amplitude is substantially equal to the desired value.

A large disadvantage of this circuit is that a large minimum voltage drop is required across the transistors 2, 3, 5 and 6, more precisely between supply voltage node 10 and left output node 16, between supply voltage node 10 and right output node 17, between left output node 16 and feedback node 13, and between right output node 17 and feedback node 13. These voltage drops imply that an appreciable amount of power is dissipated in the transistors, which lowers the overall efficiency of the H-bridge circuit.

Another disadvantage of this circuit is that the load current amplitude must be controlled via an overall control loop, which can be complex, and stability problems may arise depending on the load characteristics.

Document US 2005/0264920 A1 discloses a coil driver which has three modes of operation: a linear mode, a PWM mode, and a transition mode between linear and PWM mode. In each one of these modes, the bridge transistors are operated in the same regime (linear mode or switching mode).

Document US 6,374,043 discloses a circuit to provide drive voltages to a voice coil motor (VCM) of a hard disk drive. The disclosed circuit has identical high and low side drivers connected to the VCM. Each driver has an output FET selectively connecting the VCM to a control voltage.

Documents US 2005/218843 and US 2005/226018 disclose an H-bridge circuit for applying a driving current to a motor. The H-bridge circuit comprises two linear-mode transistors and two switching-mode transistors controlled by a state control circuit. A feedback circuit is provided, which selectively applies the difference between the detected driving current and a command signal as an error signal to either the one or the other of the linear-mode transistors in such a way as to control the driving current to become proportional to the command signal.

### Technical problem

It is an object of the present invention to provide an H-bridge circuit for supplying a precisely defined current to an electrical load in a more efficient way.

This object is achieved by a H-bridge circuit for supplying a load with a defined current as claimed in claim 1.

### General Description of the Invention

In order to overcome the above-mentioned problem, the present invention proposes a H-bridge circuit for supplying a load with a defined current, comprising a first transistor for coupling a first terminal of said load to a positive potential of a power source; a second transistor for coupling said first terminal of said load to a negative potential of said power source; a third transistor for coupling a second terminal of said load to said positive potential of said power source; and a fourth transistor for coupling said second terminal of said load to said negative potential of said power source. The circuit further comprises a current sensing circuitry for sensing a current flowing through said load and for generating a voltage signal representative of said current, and a control circuit for individually controlling the operation of said first, second, third and fourth transistors by respective first, second, third and fourth control signals, said control circuit being configured for operating two transistors of said first, second, third and fourth transistors in switching mode and for operating the remaining two transistors in linear mode. According to the invention, each of said linear mode transistors has associated therewith a feedback circuit, which is operatively coupled to the control circuit and to the current sensing circuitry. Each such feedback circuit comprises a resistive element coupled between the gate/base of the associated linear mode transistor and the power source. The feedback circuits further comprise a feedback transistor coupled between the gate/base of the associated linear mode transistor and the current sensing circuitry, the base/gate of the feedback transistor being connected to the control circuit for receiving the control signal for the associated linear mode transistor. The feedback transistor controls the voltage on the gate/base of the associated linear mode transistor so that a difference between the voltage signal of said current sensing circuitry and the respective control signal from said control circuit is maintained at a constant level.

In contrast to the above described state of the art H-bridge circuits, the present invention operates one half of the H-bridge in switching mode and the other in linear mode. Furthermore, each of the linear mode transistors is controlled by a local feedback loop, which is much more efficient and less complex than the prior art overall control loop for controlling the load current amplitude.

In a preferred embodiment, said feedback circuit comprises a feedback transistor coupled between the gate/base of the associated linear mode transistor and the current sensing circuitry and a resistive element coupled between the gate/base of the associated linear mode transistor and the power source. The base/gate of said feedback transistor is connected to said control circuit for receiving the control signal for the associated linear mode transistor.

The feedback transistor is preferably coupled with its emitter/source to said current sensing circuitry and said control signal for the associated linear mode transistor is substantially equal to the sum of a reference signal representative of the current signal to be supplied by the associated linear mode transistor and the base-emitter voltage drop resp. the gate-source voltage drop of the feedback transistor. The reference signal is e.g. the voltage signal that the desired current supplied by the associated linear mode transistor generates at the current sensing circuitry.

According to a preferred variant of the invention, the feedback circuits associated to the one linear mode transistor comprises a first feedback transistor and the feedback circuit associated to the other linear mode transistor comprises a second, separate, feedback transistor. In this case, each of the first and second feedback transistors is coupled between the gate/base of the associated linear mode transistor and the current sensing circuitry, respectively. Furthermore, the control circuit comprises individual control nodes connected to the base/gate of the first and second feedback transistor, respectively.

It shall be noted that the feedback circuits can have components in common: for instance, the feedback circuits could share a common feedback transistor instead of two separate ones. According to another preferred variant of the invention, the feedback circuit associated to the one linear mode transistor and the feedback circuit associated to the other linear mode transistor thus comprise a common feedback transistor. In this variant, the control circuit comprises a common control node connected to the base/gate of the common feedback transistor, which outputs the control signals for both linear mode transistors in a temporally interfaced (i.e. temporally multiplexed) manner. The control circuit preferably comprises an electronic switch in order to switch the common feedback transistor alternatively to the one and the other of the associated linear mode transistors. Such electronic switch may e.g. be controlled with one of the control signals for controlling the transistors operating in switching mode.

The (first, second or common) feedback transistors are preferably bipolar transistors, which are characterized by a more stable operation under varying temperature conditions. On the other hand, the first, second, third and fourth transistors are preferably MOSFET transistors, which are known for their faster switching and their reduced power consumption.

In a very simple embodiment, the current sensing circuitry comprises a shunt resistor coupled between the first and the third transistor and said positive potential of said power source or between the second and the fourth transistor and said negative potential of said power source, such that the current flowing though said load produces a potential difference across said shunt resistor.

### Brief Description of the Drawings

Preferred embodiments of the invention will now be described, by way of example, with reference to the accompanying drawings in which:
- Fig. 1: shows a circuit diagram of a prior art H-bridge circuit;
- Fig. 2: shows a circuit diagram of a first embodiment of a H-bridge circuit according to the present invention;
- Fig. 3: illustrates the different signals during the operation of the circuit shown in Fig. 2;
- Fig. 4: shows a circuit diagram of a second embodiment of a H-bridge circuit according to the present invention;
- Fig. 5: illustrates the different signals during the operation of the circuit shown in Fig. 4.

### Description of Preferred Embodiments

A possible implementation of a H-bridge in accordance with the present invention is shown in Fig. 2. In this circuit diagram, the different reference numerals denote the following elements:
- 1: a power supply voltage source,
- 4: the load,
- 7: a shunt resistor,
- 8: the circuit ground,
- 10: the supply voltage node,
- 20: a control circuit,
- 21, 24: P-channel Mosfets,
- 22, 23: N-channel Mosfets,
- 25, 26: NPN transistors,
- 27, 28: pullup resistors,
- 31: the control node for transistor 25,
- 32: the control node for Mosfet 22,
- 33: the control node for Mosfet 23,
- 34: the control node for transistor 26,
- 35: the upper node of shunt resistor 7.

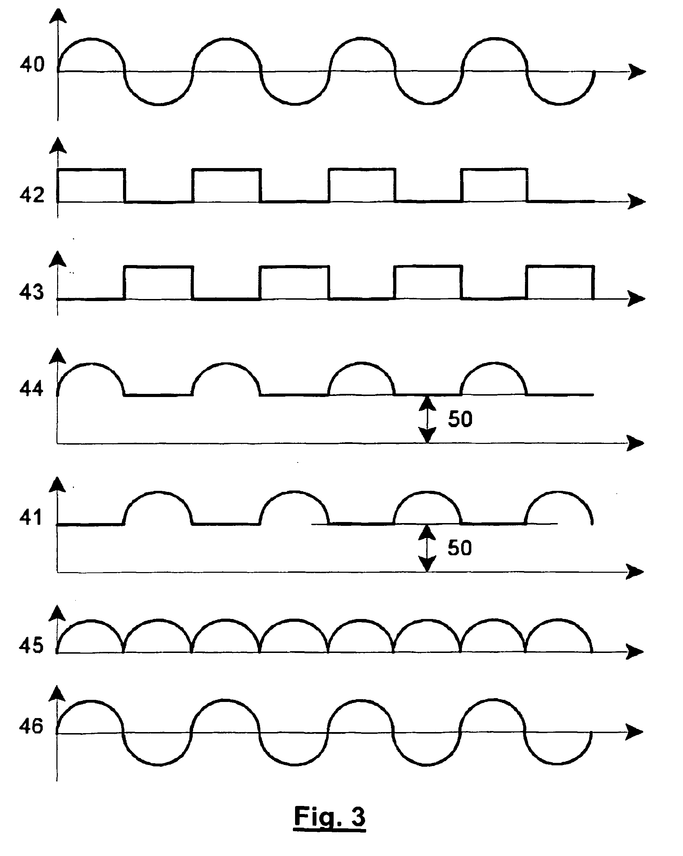

The curves in Fig. 3 illustrate the different signals during the operation of the circuit shown in Fig. 2.
- 40: an example of the desired current waveform,
- 41: the waveform of the voltage on control node 31,
- 42: the waveform of the voltage on control node 32,
- 43: the waveform of the voltage on control node 33,
- 44: the waveform of the voltage on control node 34,
- 45: the waveform of the voltage on upper node 35 of shunt resistor 7,
- 46: the current through the load 4,
- 50: a voltage which is substantially equal to the base-emitter voltage drop (Vbe) of transistors 25 and 26 (e.g. ≈0,7 V for bipolar transistors).

Four periods of the relevant signals in Fig. 2 are shown in Fig. 3. The signals shown in Fig. 3 are only an illustrative example for signals which may occur in an implementation of the circuit shown in Fig.2. When a different load current signal is required, the signal forms shown in Fig.3 will be different.

The control circuit 9 transforms the required signal 40 into the four control signals 41, 42, 43, 44 on control nodes 31, 32, 33, 34 respectively. The control circuit needs not necessarily transform the required signal into the control signals, it can also generate the control signals individually from scratch.

Control signal 42 is high whenever the required signal 40 is positive and low otherwise. Control signal 43 is high whenever the required signal 40 is negative and low otherwise.

Control signal 44 is substantially equal to the sum of the required signal 40 and the base-emitter voltage drop 50 (Vbe) of transistors 25 and 26 during the first half of each period, and substantially equal to the base-emitter voltage drop 50 (Vbe) of transistors 25 and 26 during the second half of each period.

Control signal 41 is substantially equal to the sum of the required signal 40 and the base-emitter voltage drop 50 (Vbe) of transistors 25 and 26 during the second half of each of its periods, and substantially equal to the base-emitter voltage drop 50 (Vbe) of transistors 25 and 26 during the first half of each of its periods.

In the circuit of Fig.2, transistors 21 and 24 are operated as controlled current sources, while transistors 22 and 23 are operated as switches with low switch voltage drop.

During the first half period of the required signal 40, the control signal 42 is set to high level, thereby switching on transistor 22. Control signal 43 is low, thereby switching off transistor 23. Control signal 44 is substantially equal to the sum of the required signal 40 and the base-emitter voltage drop 50 (Vbe) of transistor 26. Control signal 41 is substantially equal to the base-emitter voltage drop 50 (Vbe) of transistor 26. Transistors 24, 22 and 26, load 4 and shunt resistor 7 form a first load current control loop during the first half of each period. The supply current flows from the power supply voltage source 1 through transistor 24, the load 4, transistor 22, shunt resistor 7, into circuit ground 8 and back into supply voltage source 1. The aforementioned first load current control loop keeps the current through the load substantially equal to the required signal 40 divided by the resistance of the shunt resistor 7 in the following way: the current through the load also flows through the shunt resistor 7, thereby creating a voltage on the upper node 35 of the shunt resistor 7, which is equal to the current through the load multiplied by the resistance of shunt resistance 7.The difference between the voltage on the control node 34 and the voltage on the node 35 is equal to the voltage at the base-emitter input voltage of transistor 26. The base-emitter voltage sets, by the well-known exponential relationship between base-emitter voltage and collector current of a bipolar transistor, the collector current of transistor 26. If the aforementioned difference between the voltage on the control node 34 and the voltage on the node 35 increases, the collector current into transistor 26 increases as an exponential function of the aforementioned voltage difference. This collector current flows through the pullup resistor 28, thereby pulling down the voltage on the gate of transistor 24, and thereby increasing the current flowing through transistor 24 (because, in Fig. 2, transistor 24 is a P-channel MOSFET connected in common source configuration). This same current flows from the supply voltage node 10 into the load 4, thereby increasing the current through shunt resistor 7, and thereby increasing the voltage on the upper node 35 of the shunt resistor 7. Essentially the same procedure happens, but in opposite direction, if the aforementioned difference between the voltage on the control node 34 and the voltage on the node 35 decreases.

As the relation between the base-emitter voltage and the collector current is exponential, and the collector current will settle to a value which is determined by resistor 28 and the threshold gate voltage of transistor 24, whereby this value will typically not vary more than one order of magnitude, the base-emitter voltage, and thus the difference between the voltage on the control node 34 and the voltage on the node 35 will remain substantially constant due to the aforementioned exponential relationship, typically around 0.6V to 0.7V. A typical value for the resistance of resistor 28 is 1 k Ohm for example and a typical value for the threshold gate voltage of transistor 24 is for example 5V for a load current of 1A. In summary, the first control loop adjusts the current through the load until the voltage on the upper node 35 of the shunt resistor 7, signal 45 in Fig. 3, is substantially equal to the voltage on the control node 34 minus the base-emitter voltage drop 50 (Vbe) of transistor 26, which is substantially equal to the required signal 40.

During the second half period of the required signal 40, the control signal 43 is set to high level, thereby switching on transistor 23. Control signal 42 is low, thereby switching off transistor 22. Control signal 41 is substantially equal to the sum of the required signal 40 and the base-emitter voltage drop 50 (Vbe) of transistor 25. Control signal 44 is substantially equal to the base-emitter voltage drop 50 (Vbe) of transistor 25. Transistors 21, 23 and 25, load 4 and shunt resistor 7 form a second load current control loop during the second half of each period. The supply current flows from the power supply voltage source 1 through transistor 21, the load 4, transistor 23, shunt resistor 7, into circuit ground 8 and back into supply voltage source 1. Similarly to the first control loop, the second control loop controls the current through the load, signal 46 in Fig.3, in such a way that it is substantially equal to the required signal divided by the resistance of shunt resistor 7 during the second half of each period

Finally, as the two control loops operate alternatively, the current through the load 4 is consequently always substantially equal to the required signal divided by the resistance of shunt resistor 7.

It is obvious that the control signal 44 needs not to be kept substantially equal to the base-emitter voltage drop 50 (Vbe) of transistor 26 during the first half of each period, it is sufficient that the voltage level of control signal 44 is sufficiently low so that transistor 26 is kept off during the first half of each period. Also, it is obvious that the control signal 41 needs not to be kept substantially equal to the base-emitter voltage drop 50 (Vbe) of transistor 25 during the first half of each period, it is sufficient that the voltage level of control signal 41 is sufficiently low so that transistor 25 is kept off during the first half of each period.

The required voltage level shift of one base-emitter voltage drop (Vbe) of transistors 25 and 26, between the required signal and the control signal 44 during the first half of each period, and between the required signal and the control signal 41 during the second half of each period can easily be implemented by using one additional transistor for each of the level shifts, for example a PNP bipolar transistor configured as voltage follower.

It will be noted, that instead of the bipolar transistors shown in fig. 2 other transistor types, like Mosfet transistors can be used instead, and instead of the Mosfet transistors shown in this figure other transistor types, like bipolar transistors can be used instead. Furthermore the load is shown in the circuit diagram as resistor, but other load types, such as complex or non-linear loads may also be used instead.

The pullup resistors 27 and 28 can also be replaced by current sources.

The control circuit 20 can be any electronic circuit that is capable of generating the desired signals of nodes 31, 32, 33, 34. In a typical application, control circuit 20 can be a microcontroller with digital output signal nodes 32, 33 and with two additional digital-to-analog converters connected to and driven by the microcontroller, where the outputs of the digital-to-analog converters then correspond to signal nodes 31 and 34 in Fig. 2. In another typical implementation, control circuit 20 can be a field programmable array (FPGA) with digital output signal nodes 32, 33 and with two additional digital-to-analog converters connected to and driven by the FPGA, where the outputs of the digital-to-analog converters then correspond to signal nodes 31 and 34 in Fig. 2.

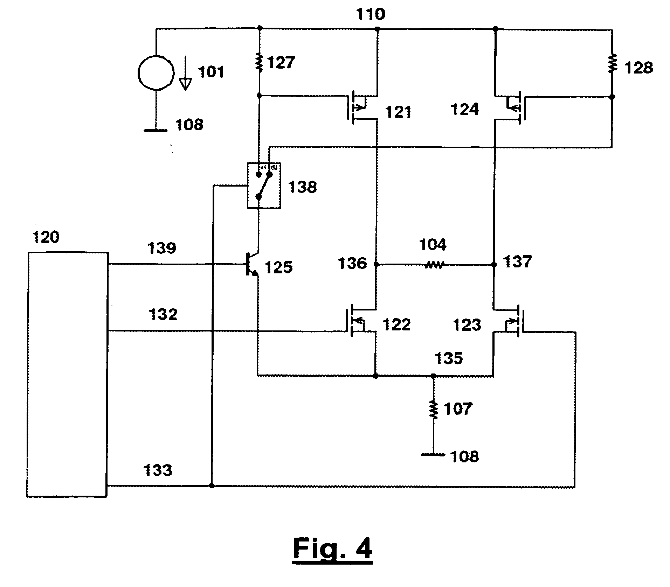

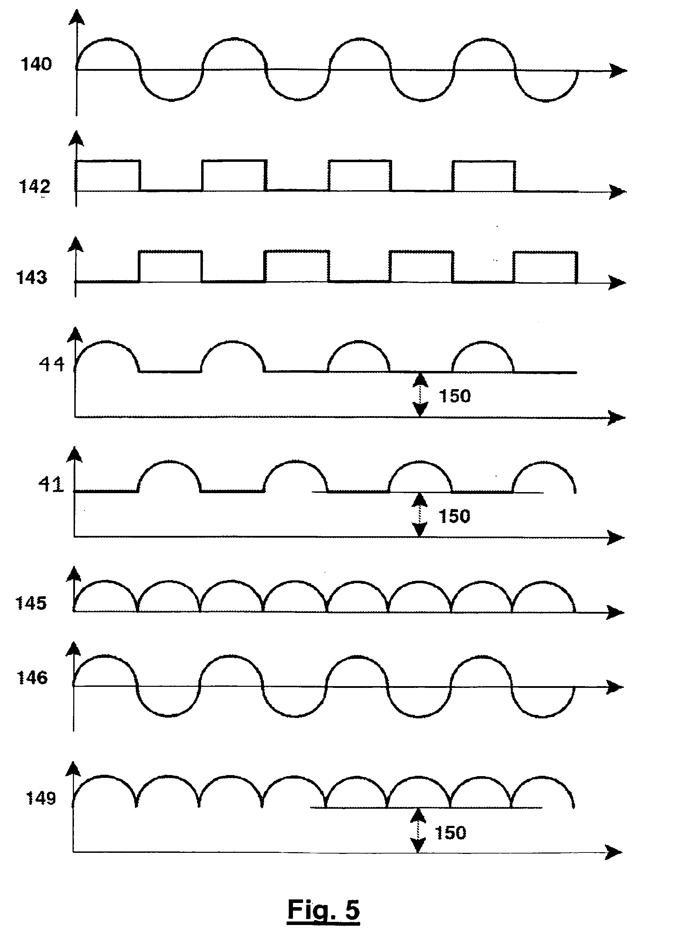

Another possible implementation of a H-bridge in accordance with the present invention is now discussed with reference to Figs. 4 and 5. In this implementation, the feedback circuits share a common feedback transistor, which alternately controls the linear mode transistors. In the circuit diagram of Fig. 4, the different reference numerals denote the following elements:
- 101: a power supply voltage source,
- 104: the load,
- 107: a shunt resistor,
- 108: the circuit ground,
- 110: the supply voltage node,
- 120: a control circuit,
- 121, 124: P-channel Mosfets,
- 122, 123: N-channel Mosfets,
- 125: NPN transistor,
- 127, 128: are pullup resistors,
- 132: the control node for Mosfet 122,
- 133: the control node for Mosfet 123 and electronic switch 138,
- 135: the upper node of shunt resistor 107,
- 138: an electronic switch,
- 139: the control node for transistor 125.

Reference numeral 138 designates an analog electronic switch. The switching state is controlled by the control input connected to node 133. When the control input is set to a low level, the switch 138 is set to a first state in which the collector of transistor 125 is connected to the gate of transistor 124 and the gate of transistor 121 is not connected to the collector of transistor 125. When the control input is set to a high level, the switch 138 is set to a second state in which the collector of transistor 125 is connected to the gate of transistor 121 and the gate of transistor 124 is not connected to the collector of transistor 125. An example for electronic switch 138 is the integrated circuit CD4053 from Fairchild Semiconductor but there are numerous alternatives available on the market.

The curves in Fig. 5 illustrate the different signals during the operation of the circuit shown in Fig. 4.
- 140: an example of the desired current waveform,
- 142: the waveform of the voltage on control node 132,
- 143: the waveform of the voltage on control node 133,
- 145: the waveform of the voltage on upper node 135 of shunt resistor 107,
- 146: the current through the load 104,
- 149: the waveform of the voltage on control node 139,
- 150: a voltage that is substantially equal to the base-emitter voltage drop (Vbe) of transistor 125 (e.g. ≈0.7 V for bipolar transistors).

For enabling easier comparison with the embodiment of Figs. 2 and 3, Fig. 5 also shows the waveforms 41 and 44 for the control nodes 31 and 34 of Fig. 2.

Four periods of the relevant signals in Fig. 4 are shown in Fig. 5. The signals shown in Fig. 5 are only an illustrative example for signals that may occur in an implementation of the circuit shown in Fig. 4. When a different load current signal is required, the signal forms shown in Fig. 5 will be different.

The control circuit 109 transforms the required signal 140 into the control signals 142, 143, 149 on control nodes 132, 133, 139 respectively. The control circuit needs not necessarily transform the required signal into the control signals; it can also generate the control signals individually from scratch.

Control signal 142 is high whenever the required signal 140 is positive and low otherwise. Control signal 143 is high whenever the required signal 140 is negative and low otherwise.

The control signals for the feedback circuit associated with linear mode transistor 121 and for the feedback circuit associated with linear mode transistor 124 are time-multiplexed in signal 149. During the first half of each period of the required signal 140, signal 149 is substantially equal to the sum of the required signal 140 and the base-emitter voltage drop 150 (Vbe) of transistor 125 (and thus correspond to control signal 44 during these time intervals). During the second half of each period of the required signal 140, signal 149 is substantially equal to the sum of the inverted required signal 140 and the base-emitter voltage drop 150 (Vbe) of transistor 125 (and thus correspond to control signal 41 during these time intervals).

In the circuit of Fig. 4, transistors 121 and 124 are operated as controlled current sources, while transistors 122 and 123 are operated as switches with low switch voltage drop.

During the first half period of the required signal 140, the control signal 142 is set to high level, thereby switching on transistor 122. Control signal 143 is low, thereby switching off transistor 123 and connecting the collector of transistor 125 to the gate of transistor 124 through the action of the electronic switch 138. Control signal 149 is substantially equal to the sum of the required signal 140 and the base-emitter voltage drop 150 (Vbe) of transistor 125.

Transistors 124, load 104, transistor 122, shunt resistor 107, transistor 125 and electronic switch 138 form a load current control loop during the first half of each period. The supply current flows from the power supply voltage source 101 through transistor 124, the load 104, transistor 122, shunt resistor 107, into circuit ground 108 and back into supply voltage source 101. The aforementioned load current control loop keeps the current through the load substantially equal to the required signal 140 in the following way: the current through the load flows through the shunt resistor 107, thereby creating a voltage on the upper node 135 of the shunt resistor 107, which is equal to the current through the load multiplied by the resistance of shunt resistance 107.

The difference between the voltage on the control node 139 and the voltage on the node 135 is equal to the voltage at the base-emitter input voltage of transistor 125. The base-emitter voltage sets, by the well-known exponential relationship between base-emitter voltage and collector current of a bipolar transistor, the collector current of transistor 125. If the aforementioned difference between the voltage on the control node 139 and the voltage on the node 135 increases, the collector current into transistor 125 increases as an exponential function of the aforementioned voltage difference. This collector current flows through the electronic switch 138 and the pullup resistor 128, thereby pulling down the voltage on the gate of transistor 124, and thereby increasing the current flowing through transistor 124 (because, in Fig. 4, transistor 124 is a P-channel MOSFET connected in common source configuration). This same current flows from the supply voltage node 110 into the load 104, thereby increasing the current through shunt resistor 107, and thereby increasing the voltage on the upper node 135 of the shunt resistor 107. Essentially the same procedure happens, but in opposite direction, if the aforementioned difference between the voltage on the control node 139 and the voltage on the node 135 decreases.

As the relation between the base-emitter voltage and the collector current is exponential, and the collector current will settle to a value which is determined by resistor 128 and the threshold gate voltage of transistor 124, whereby this value will typically not vary more than one order of magnitude, the base-emitter voltage, and thereby the difference between the voltage on the control node 139 and the voltage on the node 135 will remain substantially constant due to the aforementioned exponential relationship, typically around 0.6V to 0.7V. A typical value for the resistance of resistor 128 is 1 k Ohm for example and a typical value for the threshold gate voltage of transistor 124 is for example 5V for a load current of 1A. In summary, the control loop increases or decreases the current through the load until the voltage on the upper node 139 of the shunt resistor 107, signal 145 in Fig. 5, is substantially equal to the voltage on the control node 139 minus the base-emitter voltage drop 150 (Vbe) of transistor 125, which is substantially equal to the required signal 140.

During the second half period of the required signal 140, the control signal 143 is set to high level, thereby switching on transistor 123 and connecting the collector of transistor 125 to the gate of transistor 121 through the action of the electronic switch 138. Control signal 142 is low, thereby switching off transistor 122. Control signal 149 is substantially equal to the sum of the inverted required signal 140 and the base-emitter voltage drop 150 (Vbe) of transistor 125.

Transistors 121, load 104, transistor 123, shunt resistor 107, transistor 125 and electronic switch 138 form a load current control loop during the second half of each period. The supply current flows from the power supply voltage source 101 through transistor 121, the load 104, transistor 123, shunt resistor 107, into circuit ground 108 and back into supply voltage source 101. Similarly to the control loop of the first half of each period, the control loop now controls the current through the load.

The control circuit 120 can be any electronic circuit that is capable of generating the desired signals on nodes 132, 133, 139. In a typical application, control circuit 120 can be a microcontroller with digital output signal nodes 132, 133 and with a digital-to-analog converters connected to and driven by the microcontroller, where the output of the digital-to-analog converter then corresponds to signal node 139 in Fig. 4. In another typical implementation, control circuit 120 can be a field programmable array (FPGA) with digital output signal nodes 132, 133 and a digital-to-analog converter connected to and driven by the FPGA, where the output of the digital-to-analog converter then corresponds to signal node 139 in Fig. 4.

It should be noted that the desired current waveforms 40 and 140 represented in Figs. 3 and 5, respectively, needs not to be physically present in the circuit. If the signal is present, the control circuits 20 and 120 can use it as a template to generate the control signals.

## Claims

1. An H-bridge circuit for supplying a load (4, 104) with a defined current, comprising
a first transistor (21, 121) for coupling a first terminal (36, 136) of said load (4, 104) to a positive potential of a power source (1, 101);
a second transistor (22, 122) for coupling said first terminal (36, 136) of said load (4, 104) to a negative potential of said power source (1, 101);
a third transistor (24, 124) for coupling a second terminal (37, 137) of said load (4, 104) to said positive potential of said power source (1, 101);
a fourth transistor (23, 123) for coupling said second terminal (37, 137) of said load (4, 104) to said negative potential of said power source (1, 101);
a current sensing circuitry (7, 107) for sensing a current flowing through said load (4, 104) and for generating a voltage signal representative of said current,
and a control circuit (20, 120) for individually controlling the operation of said first, second, third and fourth transistors by respective first, second, third and fourth control signals (41, 42, 43, 44; 142, 143, 145, 149), said control circuit (20, 120) being configured for operating two transistors (22, 23; 122, 123) of said first, second, third and fourth transistors in switching mode and for operating the remaining two transistors (21, 24; 121, 124) in linear mode; wherein
each of said linear mode transistors (21, 24; 121, 124) has a feedback circuit associated therewith, said feedback circuit being operatively coupled to said control circuit (20, 120) and to said current sensing circuitry (7, 107), **characterized in that**
said feedback circuit comprises
a resistive element (27, 28,; 127, 128) coupled between the gate/base of the associated linear mode transistor (21, 24; 121, 124) and the power source (1, 101),
a feedback transistor (25, 26, 125) coupled between the gate/base of the associated linear mode transistor (21, 24; 121, 124) and the current sensing circuitry (7, 107), the base/gate of said feedback transistor (25, 26, 125) being connected to said control circuit (20, 120) for receiving the control signal (41, 44, 149) for the associated linear mode transistor (21, 24; 121, 124),
wherein said feedback transistor (25, 26, 125) controls the voltage on the gate/base of the associated linear mode transistor (21, 24; 121, 124) in such a way that a difference between the voltage signal of said current sensing circuitry (7, 107) and the respective control signal (41, 44, 149) from said control circuit (20, 120) is maintained at a substantially constant level.

2. The H-bridge circuit as claimed in claim 1, wherein said feedback transistor (25, 26, 125) is coupled with its emitter/source to said current sensing circuitry (7, 107) and wherein said control signal (41, 44, 149) for the associated linear mode transistor (21,24;121,124) is substantially equal to the sum of a reference signal representative of the current signal to be supplied by the associated linear mode transistor (21,24;121,124) and the base-emitter voltage drop resp. the gate-source voltage drop of the feedback transistor (25, 26, 125).

3. The H-bridge circuit as claimed in claim 1 or 2, wherein said first (21, 121), second (22, 122), third (24, 124) and fourth (23, 123) transistors are MOSFET transistors.

4. The H-bridge circuit as claimed in any one of claims 1 to 3, wherein said current sensing circuitry comprises a shunt resistor (7, 107) coupled between the first (21, 121) and the third transistor (24, 124) and said positive potential of said power source (1, 101) or between the second (22, 122) and the fourth (23, 123) transistor and said negative potential (8) of said power source (1, 101), such that the current flowing through said load (4, 104) produces a potential difference across said shunt resistor (7, 107).

5. The H-bridge circuit as claimed in any one of claims 1 to 4,
wherein the feedback circuit associated to the one linear mode transistor (21) comprises a first feedback transistor (25) and the feedback circuit associated to the other linear mode transistor (24) comprises a second feedback transistor (26),
wherein said control circuit (20) comprises individual control nodes (31, 34) connected to the base/gate of the first (25) and second (26) feedback transistor, respectively, for outputting the control signals for the linear mode transistors (21, 24); and
wherein each of said first and second feedback transistors (25, 26) is coupled between the gate/base of the associated linear mode transistor (21, 24) and the current sensing circuitry (7), respectively.

6. The H-bridge circuit as claimed in claim 5, wherein said first and second feedback transistors (25, 26) are bipolar transistors.

7. The H-bridge circuit as claimed in any one of claims 1 to 4,
wherein the feedback circuit associated to the one linear mode transistor (121) and the feedback circuit associated to the other linear mode transistor (124) comprise a common feedback transistor (125), and
wherein said control circuit (120) comprises a common control node (139) connected to the base/gate of the common feedback transistor (125), said common control node (139) outputting the control signals (149) for the linear mode transistors (121, 124) in a temporally interlaced manner.

8. The H-bridge circuit as claimed in claim 7, wherein said common feedback transistor (125) is bipolar transistor.

9. The H-bridge circuit as claimed in claim 7 or 8, wherein said control circuit (120) comprises an electronic switch (138) to switch said common feedback transistor (125) alternatively to the one or the other of the associated linear mode transistors (121, 124).

10. The H-bridge circuit as claimed in claim 9, wherein said electronic switch (138) is controlled with one of the control signals (143) for controlling the transistors (122, 123) operating in switching mode.

## Patentansprüche

1. H-Brückenschaltung zur Speisung einer Last (4, 104) mit einem definierten Strom, umfassend
einen ersten Transistor (21, 121) zum Koppeln einer ersten Anschlussklemme (36, 136) der Last (4, 104) mit einem positiven Potential einer Energiequelle (1, 101);
einen zweiten Transistor (22, 122) zum Koppeln der ersten Anschlussklemme (36, 136) der Last (4, 104) mit einem negativen Potential der Energiequelle (1, 101);
einen dritten Transistor (24, 124) zum Koppeln einer zweiten Anschlussklemme (37, 137) der Last (4, 104) mit dem positiven Potential der Energiequelle (1, 101);
einen vierten Transistor (23, 123) zum Koppeln der zweiten Anschlussklemme (37, 137) der Last (4, 104) mit dem negativen Potential der Energiequelle (1, 101);
eine Stromerfassungsschaltung (7, 107) zur Erfassung eines durch die Last (4, 104) fließenden Stroms und zur Erzeugung eines für den Strom repräsentativen Spannungssignals,
und eine Steuerschaltung (20, 120) zur einzelnen Steuerung des Betriebs des ersten, zweiten, dritten und vierten Transistors durch ein jeweiliges erstes, zweites, drittes und viertes Steuersignal (41, 42, 43, 44; 142, 143, 145, 149), wobei die Steuerschaltung (20, 120) für den Betrieb von zwei Transistoren (22, 23; 122, 123) des ersten, zweiten, dritten und vierten Transistors im Schaltmodus und für den Betrieb der übrigen zwei Transistoren (21, 24; 121, 124) im Linearmodus konfiguriert ist;
wobei
jeder der Linearmodus-Transistoren (21, 24; 121, 124) eine ihm zugeordnete Rückkopplungsschaltung aufweist, wobei die Rückkopplungsschaltung mit der Steuerschaltung (20, 120) und der Stromerfassungsschaltung (7, 107) wirkgekoppelt ist,
**dadurch gekennzeichnet, dass**
die Rückkopplungsschaltung Folgendes umfasst:
ein Widerstandselement (27, 28; 127, 128), das zwischen dem Gatter/der Basis des zugeordneten Linearmodus-Transistors (21, 24; 121, 124) und der Energiequelle (1, 101) gekoppelt ist,
einen Rückkopplungstransistor (25, 26, 125), der zwischen dem Gatter/der Basis des zugeordneten Linearmodus-Transistors (21, 24; 121, 124) und der Stromerfassungsschaltung (7, 107) gekoppelt ist, wobei die Basis/das Gatter des Rückkopplungstransistors (25, 26, 125) an die Steuerschaltung (20, 120) angeschlossen ist, um das Steuersignal (41, 44, 149) für den zugeordneten Linearmodus-Transistor (21, 24; 121, 124) zu empfangen,
wobei der Rückkopplungstransistor (25, 26, 125) die Spannung an dem Gatter/der Basis des zugeordneten Linearmodus-Transistors (21, 24; 121, 124) derart steuert, dass eine Differenz zwischen dem Spannungssignal der Stromerfassungsschaltung (7, 107) und dem jeweiligen Steuersignal (41, 44, 149) von der Steuerschaltung (20, 120) bei einem im Wesentlichen gleichmäßigen Pegel beibehalten wird.

2. H-Brückenschaltung nach Anspruch 1, wobei der Rückkopplungstransistor (25, 26, 125) mit seinem Emitter/seiner Source mit der Stromerfassungsschaltung (7, 107) gekoppelt ist und wobei das Steuersignal (41, 44, 149) für den zugeordneten Linearmodus-Transistor (21, 24; 121, 124) im Wesentlichen gleich der Summe aus einem Referenzsignal, das repräsentativ für das von dem zugeordneten Linearmodus-Transistor (21, 24; 121, 124) zu speisende Stromsignal ist, und dem Basis-Emitter-Spannungsabfall bzw. dem Gatter-Source-Spannungsabfall des Rückkopplungstransistors (25, 26, 125) ist.

3. H-Brückenschaltung nach Anspruch 1 oder 2, wobei der erste (21, 121), zweite (22, 122), dritte (24, 124) und vierte (23, 123) Transistor MOSFET-Transistoren sind.

4. H-Brückenschaltung nach irgendeinem der Ansprüche 1 bis 3, wobei die Stromerfassungsschaltung einen Nebenschlusswiderstand (7, 107) umfasst, der zwischen dem ersten (21, 121) und dem dritten Transistor (24, 124) und dem positiven Potential der Energiequelle (1, 101) oder zwischen dem zweiten (22, 122) und dem vierten (23, 123) Transistor und dem negativen Potential (8) der Energiequelle (1, 101) derart gekoppelt ist, dass der durch die Last (4, 104) fließende Strom eine Potentialdifferenz über dem Nebenschlusswiderstand (7, 107) erzeugt.

5. H-Brückenschaltung nach irgendeinem der Ansprüche 1 bis 4,
wobei die dem einen Linearmodus-Transistor (21) zugeordnete Rückkopplungsschaltung einen ersten Rückkopplungstransistor (25) umfasst und die dem anderen Linearmodus-Transistor (24) zugeordnete Rückkopplungsschaltung einen zweiten Rückkopplungstransistor (26) umfasst,
wobei die Steuerschaltung (20) einzelne Steuerknoten (31, 34) umfasst, die an die Basis/das Gatter des ersten (25) bzw. zweiten (26) Rückkopplungstransistors angeschlossen sind, um die Steuersignale für die Linearmodus-Transistoren (21, 24) auszugeben; und
wobei jeder von dem ersten und zweiten Rückkopplungstransistor (25, 26) zwischen dem Gatter/der Basis des zugeordneten Linearmodus-Transistors (21, 24) und der Stromerfassungsschaltung (7) gekoppelt ist.

6. H-Brückenschaltung nach Anspruch 5, wobei der erste und zweite Rückkopplungstransistor (25, 26) bipolare Transistoren sind.

7. H-Brückenschaltung nach irgendeinem der Ansprüche 1 bis 4,
wobei die dem einen Linearmodus-Transistor (121) zugeordnete Rückkopplungsschaltung und die dem anderen Linearmodus-Transistor (124) zugeordnete Rückkopplungsschaltung einen gemeinsamen Rückkopplungstransistor (125) umfassen und
wobei die Steuerschaltung (120) einen gemeinsamen Steuerknoten (139) umfasst, der an die Basis/das Gatter des gemeinsamen Rückkopplungstransistors (125) angeschlossen ist, wobei der gemeinsame Steuerknoten (139) die Steuersignale (149) für die Linearmodus-Transistoren (121, 124) in einer zeitlich verschachtelten Weise ausgibt.

8. H-Brückenschaltung nach Anspruch 7, wobei der gemeinsame Rückkopplungstransistor (125) ein bipolarer Transistor ist.

9. H-Brückenschaltung nach Anspruch 7 oder 8, wobei die Steuerschaltung (120) einen elektronischen Schalter (138) umfasst, um den gemeinsamen Rückkopplungstransistor (125) abwechselnd zu dem einen oder dem anderen der zugeordneten Linearmodus-Transistoren (121, 124) zu schalten.

10. H-Brückenschaltung nach Anspruch 9, wobei der elektronische Schalter (138) mit einem der Steuersignale (143) gesteuert wird, um die im Schaltmodus betriebenen Transistoren (122, 123) zu steuern.

## Revendications

1. Circuit à pont en H pour délivrer une charge (4, 104) avec un courant défini, comprenant
un premier transistor (21, 121) pour coupler une première borne (36, 136) de ladite charge (4, 104) à un potentiel positif d'une source d'énergie (1, 101) ;
un deuxième transistor (22, 122) pour coupler ladite première borne (36, 136) de ladite charge (4, 104) à un potentiel négatif de ladite source d'énergie (1, 101) ;
un troisième transistor (24, 124) pour coupler une deuxième borne (37, 137) de ladite charge (4, 104) audit potentiel positif de ladite source d'énergie (1, 101) ;
un quatrième transistor (23, 123) pour coupler ladite deuxième borne (37, 137) de ladite charge (4, 104) audit potentiel négatif de ladite source d'énergie (1, 101) ;
un circuit de détection de courant (7, 107) pour détecter un courant traversant ladite charge (4, 104) et pour générer un signal de tension représentatif dudit courant,
et un circuit de commande (20, 120) pour commander individuellement le fonctionnement desdits premier, deuxième, troisième et quatrième transistors par des premier, deuxième, troisième et quatrième signaux de commande (41, 42, 43, 44 ; 142, 143, 145, 149) respectifs, ledit circuit de commande (20, 120) étant configuré pour faire fonctionner deux transistors (22, 23 ; 122, 123) desdits premier, deuxième, troisième et quatrième transistors en mode de commutation et pour faire fonctionner les deux transistors (21, 24 ; 121, 124) restants en mode linéaire ; dans lequel
chacun desdits transistors (21, 24 ; 121, 124) en mode linéaire a un circuit de retour associé avec celui-ci, ledit circuit de retour étant opérationnellement couplé audit circuit de commande (20, 120) et audit circuit de détection de courant (7, 107),
**caractérisé en ce que**
ledit circuit de retour comprend
un élément résistif (27, 28 ; 127, 128) couplé entre la grille/base du transistor (21, 24 ; 121, 124) en mode linéaire associé et la source d'énergie (1, 101),
un transistor de retour (25, 26, 125) couplé entre la grille/base du transistor (21, 24 ; 121, 124) en mode linéaire associé et le circuit de détection de courant (7, 107), la base/grille dudit transistor de retour (25, 26, 125) étant connectée audit circuit de commande (20, 120) pour recevoir le signal de commande (41, 44, 149) pour le transistor (21, 24 ; 121, 124) en mode linéaire associé,
dans lequel ledit transistor de retour (25, 26, 125) commande la tension sur la grille/base du transistor (21, 24 ; 121, 124) en mode linéaire associé de manière à ce qu'une différence entre le signal de tension dudit circuit de détection de courant (7, 107) et le signal de commande (41, 44, 149) respectif provenant dudit circuit de commande (20, 120) soit maintenue à un niveau sensiblement constant.

2. Circuit à pont en H selon la revendication 1, dans lequel ledit transistor de retour (25, 26, 125) est couplé avec son émetteur/sa source audit circuit de détection de courant (7, 107) et dans lequel ledit signal de commande (41, 44, 149) pour le transistor (21, 24; 121, 124) en mode linéaire associé est sensiblement égal à la somme d'un signal de référence représentatif du signal de courant devant être délivré par le transistor (21, 24; 121, 124) en mode linéaire associé et de la chute de tension de la base/l'émetteur, respectivement de la chute de tension de la grille/source du transistor de retour (25, 26, 125).

3. Circuit à pont en H selon la revendication 1 ou 2, dans lequel lesdits premier (21, 121), deuxième (22, 122), troisième (24, 124) et quatrième (23, 123) transistors sont des transistors MOSFET.

4. Circuit à pont en H selon l'une quelconque des revendications 1 à 3, dans lequel ledit circuit de détection de courant comprend une résistance shunt (7, 107) couplée entre le premier (21, 121) et le troisième (24, 124) transistor et ledit potentiel positif de ladite source d'énergie (1, 101) ou entre le deuxième (22, 122) et le quatrième (23, 123) transistor et ledit potentiel négatif (8) de ladite source d'énergie (1, 101), de manière à ce que le courant traversant ladite charge (4, 104) produise une différence de potentiel au travers de ladite résistance shunt (7, 107).

5. Circuit à pont en H selon l'une quelconque des revendications 1 à 4, dans lequel le circuit de retour associé à un transistor (21) en mode linéaire comprend un premier transistor de retour (25) et le circuit de retour associé à l'autre transistor (24) en mode linéaire comprend un deuxième transistor de retour (26),
dans lequel ledit circuit de commande (20) comprend des noeuds de commande (31, 34) individuels connectés à la base/grille du premier (25) et du deuxième (26) transistor de retour, respectivement, pour délivrer en sortie les signaux de commande pour les transistors (21, 24) en mode linéaire ; et
dans lequel chacun desdits premier et deuxième transistors de retour (25, 26) est couplé entre la grille/base du transistor (21, 24) en mode linéaire associé et le circuit de détection de courant (7), respectivement.

6. Circuit à pont en H selon la revendication 5, dans lequel lesdits premier et deuxième transistors (25, 26) de retour sont des transistors bipolaires.

7. Circuit à pont en H selon l'une quelconque des revendications 1 à 4, dans lequel le circuit de retour associé à un transistor (121) en mode linéaire et le circuit de retour associé à l'autre transistor (124) en mode linéaire comprend un transistor de retour (125) commun, et
dans lequel ledit circuit de commande (120) comprend un noeud de commande (139) commun connecté à la base/grille du transistor de retour (125) commun, ledit noeud de commande (139) commun délivrant en sortie les signaux de commande (149) pour les transistors (121, 124) en mode linéaire d'une manière temporellement entrelacée.

8. Circuit à pont en H selon la revendication 7, dans lequel ledit transistor de retour (125) commun est un transistor bipolaire.

9. Circuit à pont en H selon la revendication 7 ou 8, dans lequel ledit circuit de commande (120) comprend un commutateur électronique (138) pour commuter ledit transistor de retour (125) commun de façon alternée sur l'un ou l'autre des transistors (121, 124) en mode linéaire associés.

10. Circuit à pont en H selon la revendication 9, dans lequel ledit commutateur électronique (138) est commandé avec un des signaux de commande (143) pour commander les transistors (122, 123) fonctionnant en mode de commutation.
